# EUROPEAN PATENT APPLICATION

(11) **EP 4 835 722 A1**
(43) Date of publication of application: **04.11.2026**
(21) Application number: 25910022.0
(22) Date of filing: 28.07.2025
(51) Int. Cl.: G06F 30/17

(54) **LAYOUT METHOD AND APPARATUS FOR MULTI-STAGE GEAR IN NEW ENERGY VEHICLE, AND DEVICE**

(30) Priority: 25.12.2024 CN 202411926285
(71) Applicant: Chery Automobile Co., Ltd., Wuhu, Anhui 241006 (CN); Wuhu Acteco Powertrain Co., Ltd, Wuhu, Anhui 241009 (CN)
(72) Inventor: XING, Zhijie, Wuhu, Anhui 241006 (CN); XU, Yafei, Wuhu, Anhui 241006 (CN); ZHOU, Jun, Wuhu, Anhui 241006 (CN); ZHANG, Deding, Wuhu, Anhui 241006 (CN)
(74) Representative: Adamson Jones
(86) International application number: PCT/CN2025/110968
(87) International publication number: WO 2026/137832

(57) **Abstract**

The present application relates to the technical field of new energy vehicles, and discloses a layout method and apparatus for a multi-stage gear in a new energy vehicle, a device, a storage medium, and a product. The method comprises: determining a gear arrangement space of a multi-stage gear of a new energy vehicle; on the basis of the gear arrangement space, determining a plurality of first candidate arrangement angles, the first candidate arrangement angles being candidate angles between gear shafts of the multi-stage gear; for any one of the plurality of first candidate arrangement angles, determining an overall transmission error excitation of the multi-stage gear when arrangement angles of the multi-stage gear are the first candidate arrangement angles, the overall transmission error excitation being used for representing the degree of whine generated by the multi-stage gear; on the basis of the overall transmission error excitation of the multi-stage gear when the arrangement angles of the multi-stage gear are the plurality of first candidate arrangement angles, determining, from among the plurality of first candidate arrangement angles, a first target arrangement angle having the smallest overall transmission error excitation; and on the basis of the first target arrangement angle, determining arrangement information of the multi-stage gear.

## Description

This present disclosure claims priority to Chinese Patent Application No. 202411926285.1, filed on December 25, 2024, and entitled "METHOD AND APPARATUS FOR ARRANGING MULTI-LINK GEARS IN ENERGY VEHICLE AND DEVICE," the entire contents of which are incorporated herein by reference.

### TECHNICAL FIELD

The present disclosure relates to the technical field of new energy vehicles, and particularly to a method and apparatus for arranging multi-link gears in a new energy vehicle and a device.

### BACKGROUND

With the continuous development of new energy vehicle technology, new energy vehicles are becoming increasingly popular, and competition is becoming increasingly fierce. Consumers are also imposing stringent requirements on the noise, vibration, and harshness (NVH) performance of new energy vehicles. Therefore, reducing vibration and noise is urgent. The gear noise generated by multi-link gears is one of the most important noise sources in new energy vehicles. Moreover, as new energy vehicles do not have the masking effect of traditional engine noise, which poses greater challenges for gear arrangement.

### SUMMARY

The embodiments of the present disclosure provide a method and apparatus for arranging multi-link gears in a new energy vehicle and a device. The technical solutions are as follows.

In an aspect, a method for arranging multi-link gears in a new energy vehicle is provided. The method includes:
determining a gear arrangement space for the multi-link gears of the new energy vehicle, wherein the gear arrangement space is a space allowing arrangement of the multi-link gears;
determining a plurality of first candidate arrangement angles based on the gear arrangement space, wherein the plurality of first candidate arrangement angles are candidate angles between gear shafts of the multi-link gears;
determining, for any one of the plurality of first candidate arrangement angles, an overall transmission error excitation of the multi-link gears in a case where an arrangement angle of the multi-link gears is the first candidate arrangement angle, wherein the overall transmission error excitation is configured to indicate a degree of howling generated by the multi-link gears;
determining, based on the overall transmission error excitation of the multi-link gears in the case where the arrangement angle of the multi-link gears is the first candidate arrangement angle, a first target arrangement angle with a minimum overall transmission error excitation from the plurality of first candidate arrangement angles; and
determining arrangement information of the multi-link gears based on the first target arrangement angle.

In one possible implementation, determining the overall transmission error excitation of the multi-link gears in the case where the arrangement angle of the multi-link gears is the first candidate arrangement angle includes:
determining phases of transmission error excitations at a plurality of meshing points of the multi-link gears in the case where the arrangement angle of the multi-link gears is the first candidate arrangement angle, wherein the meshing points are in one-to-one correspondence with different phases of the transmission error excitations, and the transmission error excitation at each of the meshing points is configured to indicate the degree of howling generated at the meshing point; and
determining the overall transmission error excitation of the multi-link gears based on the phases of the transmission error excitations at the plurality of meshing points.

In another possible implementation, determining the phases of the transmission error excitations of the plurality of meshing points of the multi-link gears in the case where the arrangement angle of the multi-link gears is the first candidate arrangement angle includes:
determining transmission errors of the plurality of meshing points in the case where the arrangement angle of the multi-link gears is the first candidate arrangement angle, wherein different meshing points correspond to different transmission errors, and the transmission error of the meshing point is a deviation between an actual position and a theoretical position of the multi-link gears in a case where the multi-link gears are engaged at the meshing point; and
for any one of the plurality of meshing points, acquiring the phase of the transmission error excitation at the meshing point by performing Fourier decomposition on the transmission error of the meshing point.

In another possible implementation, determining the plurality of first candidate arrangement angles based on the gear arrangement space includes:
determining a first arrangement angle range of the multi-link gears based on the gear arrangement space, wherein the first arrangement angle range is configured to constrain angles between the gear shafts of the multi-link gears; and
determining the plurality of first candidate arrangement angles from the first arrangement angle range based on a first adjustment granularity.

In another possible implementation, determining the plurality of first candidate arrangement angles from the first arrangement angle range based on the first adjustment granularity includes:
determining shafts on which the multi-link gears are disposed, acquiring a plurality of gear shafts, and determining a first gear shaft from the plurality of gear shafts; and
acquiring the plurality of first candidate arrangement angles by fixing the first gear shaft and rotating other gear shafts of the plurality of gear shafts within the first arrangement angle range based on the first adjustment granularity; or acquiring the plurality of first candidate arrangement angles by fixing other gear shafts of the plurality of gear shafts and rotating the first gear shaft within the first arrangement angle range based on the first adjustment granularity.

In another possible implementation, determining the first arrangement angle range of the multi-link gears based on the gear arrangement space includes:
determining a plurality of second candidate arrangement angles from the gear arrangement space based on a second adjustment granularity, wherein the second adjustment granularity is larger than the first adjustment granularity;
for any one of the plurality of second candidate arrangement angles, determining the overall transmission error excitation of the multi-link gears in a case where the arrangement angle of the multi-link gears is the second candidate arrangement angle;
determining, based on the overall transmission error excitation of the multi-link gears in a case where the arrangement angle of the multi-link gears is any one of the plurality of second candidate arrangement angles, a plurality of second target arrangement angles from the plurality of second candidate arrangement angles where the overall transmission error excitation is less than a predetermined error excitation; and
forming the first arrangement angle range of the multi-link gears from the plurality of second target arrangement angles.

In another aspect, an apparatus for arranging multi-link gears in a new energy vehicle is provided. The apparatus includes:
a first determination module, configured to determine a gear arrangement space for the multi-link gears in the new energy vehicle, wherein the gear arrangement space is a space allowing arrangement of the multi-link gears;
a second determination module, configured to determine a plurality of first candidate arrangement angles based on the gear arrangement space, wherein the first candidate arrangement angles are candidate angles between gear shafts of the multi-link gears;
a third determination module, configured to determine, for any one of the plurality of first candidate arrangement angles, an overall transmission error excitation of the multi-link gears in a case where the arrangement angle of the multi-link gears is the first candidate arrangement angle, wherein the overall transmission error excitation is configured to indicate a degree of howling generated by the multi-link gears;
a fourth determination module, configured to determine a first target arrangement angle with a minimum overall transmission error excitation from the plurality of first candidate arrangement angles, based on the overall transmission error excitation of the multi-link gears in a case where the arrangement angle of the multi-link gears is any one of the plurality of first candidate arrangement angles; and
a fifth determination module, configured to determine arrangement information of the multi-link gears based on the first target arrangement angle.

In one possible implementation, the third determination module is configured to: determine phases of transmission error excitations at a plurality of meshing points of the multi-link gears in the case where the arrangement angle of the multi-link gears is the first candidate arrangement angle, wherein different meshing points correspond to different phases of the transmission error excitations, and the transmission error excitation at the meshing point is configured to indicate the degree of howling generated at the meshing point; and determine, based on the phases of the transmission error excitations at the plurality of meshing points, the overall transmission error excitation of the multi-link gears.

In another possible implementation, the third determination module is configured to: determine transmission errors of the plurality of meshing points in the case where the arrangement angle of the multi-link gears is the first candidate arrangement angle, wherein different meshing points correspond to different transmission errors, and the transmission error of the meshing point is a deviation between an actual position and a theoretical position of the multi-link gears in a case where the multi-link gears are engaged at the meshing point; and for any one of the plurality of meshing points, acquire the phase of the transmission error excitation at the meshing point by performing Fourier decomposition on the transmission error of the meshing point.

In another possible implementation, the second determination module is configured to: determine a first arrangement angle range of the multi-link gears based on the gear arrangement space, wherein the first arrangement angle range is configured to constrain angles between the gear shafts of the multi-link gears; and determine the plurality of first candidate arrangement angles from the first arrangement angle range based on a first adjustment granularity.

In another possible implementation, the second determination module is configured to: determine the shaft on which the multi-link gears are disposed, acquire a plurality of gear shafts, and determine a first gear shaft from the plurality of gear shafts; and acquire the plurality of first candidate arrangement angles by fixing the first gear shaft and rotating other gear shafts of the plurality of gear shafts within the first arrangement angle range based on the first adjustment granularity; or acquire the plurality of first candidate arrangement angles by fixing other gear shafts of the plurality of gear shafts and rotating the first gear shaft within the first arrangement angle range based on the first adjustment granularity.

In another possible implementation, the second determination module is configured to: determine a plurality of second candidate arrangement angles from the gear arrangement space based on a second adjustment granularity, wherein the second adjustment granularity is larger than the first adjustment granularity; for any one of the plurality of second candidate arrangement angles, determine the overall transmission error excitation of the multi-link gears in a case where the arrangement angle of the multi-link gears is the second candidate arrangement angle; and based on the overall transmission error excitation of the multi-link gears in a case where the arrangement angle of the multi-link gears is any one of the plurality of second candidate arrangement angles, determine a plurality of second target arrangement angles from the plurality of second candidate arrangement angles where the overall transmission error excitation is less than a predetermined error excitation; and form the first arrangement angle range of the multi-link gears from the plurality of second target arrangement angles.

In another aspect, a computer device is provided. The computer device includes a processor and a memory, wherein one or more program codes are stored in the memory, the processor, when loading and executing the one or more program codes, is caused to perform the method for arranging the multi-link gears in the new energy vehicle as described above.

In another aspect, a computer-readable storage medium is provided. One or more program codes are stored in the storage medium, wherein the one or more program codes, when loaded and executed by a processor, cause the processor to perform the method for arranging the multi-link gears in the new energy vehicle as described above.

In another aspect, a computer program product is provided. The product stores one or more program codes, and the one or more program codes, when executed by a processor, cause the processor to perform the method for arranging the multi-link gears in the new energy vehicle as described above.

In the embodiments of the present disclosure, when arranging the multi-link gears, not only is the gear arrangement space considered, but also the overall transmission error excitation of the multi-link gears, which represents the degree of howling generated by the multi-link gears, is considered. Therefore, selecting the first target arrangement angle with the minimum overall transmission error excitation from the plurality of first candidate arrangement angles can reduce the noise of the multi-link gears. Thus, the embodiments of the present disclosure not only enable the arranged multi-link gears to meet the overall arrangement space and dimensional requirements of the entire box, that is, to achieve lightweight design, but also reduce the noise of the multi-link gears, that is, to ensure the NVH performance of the gears.

It should be understood that the general description above and the detailed descriptions that follow are merely exemplary and do not limit the present disclosure.

### BRIEF DESCRIPTION OF DRAWINGS

FIG. 1 is a schematic diagram of the implementation environment of the method for arranging multi-link gears in new energy vehicles according to some embodiments of the present disclosure;
FIG. 2 is a flowchart of the method for arranging the multi-link gears in the new energy vehicle according to some embodiments of the present disclosure;
FIG. 3 is a schematic diagram of multi-link gears according to some embodiments of the present disclosure;
FIG. 4 is a schematic diagram of the arrangement angle of the multi-link gears according to some embodiments of the present disclosure;
FIG. 5 is a schematic diagram of the meshing points of multi-link gears according to some embodiments of the present disclosure;
FIG. 6 is a schematic diagram of the phase of the overall transmission error excitation of the plurality of first candidate arrangement angles according to some embodiments of the present disclosure;
FIG. 7 is a flowchart of the method for arranging multi-link gears in new energy vehicles according to some embodiments of the present disclosure;
FIG. 8 is a block diagram of the apparatus for arranging the multi-link gears in the new energy vehicle according to some embodiments of the present disclosure; and
FIG. 9 is a block diagram of a computer device according to some embodiments of the present disclosure.

### DETAILED DESCRIPTION

To make the technical solutions and advantages of the present disclosure clearer, the embodiments of the present disclosure are further described in detail hereinafter.

The terms "first", "second", "third", and "fourth" in the specification, claims, and accompanying drawings of the present disclosure are used to distinguish different objects, rather than to describe a specific order. Furthermore, the terms "including" and "having" and any variations thereof are intended to cover non-exclusive inclusion. For example, processes, methods, systems, products, or devices that include a series of processes or elements are not limited to the processes or elements listed, but may optionally include processes or elements not listed, or may optionally include other processes or elements inherent to such processes, methods, products, or devices.

It should be noted that the information (including but not limited to user equipment information, user personal information, and the like), data (including but not limited to data for analysis, stored data, displayed data, and the like), and signals involved in the present disclosure are all authorized by the users or fully authorized by the parties. The collection, use, and processing of relevant data shall comply with the relevant laws, regulations, and standards of the relevant countries and regions. For example, the gear arrangement space involved in the present disclosure is acquired with full authorization.

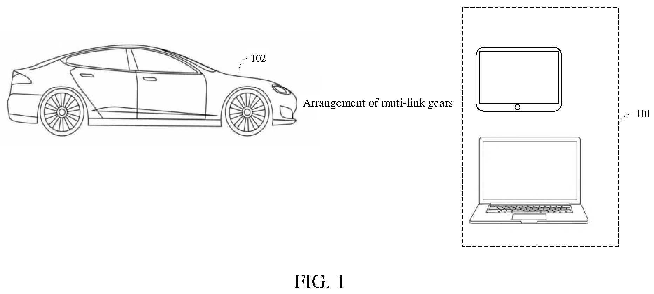

Referring to FIG. 1, FIG. 1 illustrates a schematic diagram of the implementation environment of the method for arranging the multi-link gears in a new energy vehicle according to some embodiments of the present disclosure. The implementation environment includes a computer device 101 and a new energy vehicle 102. The new energy vehicle 102 is equipped with multi-link gears, which include a plurality of gears meshed sequentially. The number of gears in the multi-link gears can be set and changed according to the needs of the new energy vehicle 102. In the embodiments of the present disclosure, there is no specific limitation on the number of gears in the multi-link gears. For example, the multi-link gears include 3 or 4 gears, or the like. In the embodiments of the present disclosure, the computer device 101 is configured to determine the arrangement of the multi-link gears in the new energy vehicle 102; and the computer device 101 employs CAE (computer aided engineering) research and analysis methods to determine the arrangement of the multi-link gears.

In one possible implementation, the development trend of the transmission system in the new energy vehicle 102 is towards strong power, good fuel efficiency, compact structure, and lightweight design. To meet the requirements of power performance and fuel efficiency, the new energy vehicle 102 often need to be equipped with motors with relatively large outer diameters. In the case where the new energy vehicle 102 operates in a multi-gear and multi-mode architecture, a plurality of clutches with larger outer diameters need to be arranged on the input shaft of the engine. To avoid interference between the clutches and the motor, there must be a large center distance between the drive shaft of the motor and the input shaft of the engine. With such a large center distance, it is difficult to transmit the power from the drive shaft of the motor to the input shaft of the engine using a pair of gears (two gears). Therefore, to accommodate this large center distance, an idler gear needs to be added between the two gears, forming a structure where three or more gears engage simultaneously, known as multi-link gears.

In another possible implementation, in a common form of multi-power coupling, the power from both the motor and the engine is ultimately transmitted to the output shaft, where they are coupled. To reduce the number of intermediate shafts and transmission gear pairs, a situation where a plurality of power sources share gear pairs is adopted, that is, the gears shared by the motor and the engine are multi-link gears.

The computer device 101 can be a tablet computer, laptop, desktop computer, smartphone, or the like, but is not limited to these. As an example, the computer device 101 is a laptop used by the developer of the new energy vehicle 102. The developer uses the computer device 101 to set the arrangement of the multi-link gears of the new energy vehicle 102.

In related technologies, when arranging the multi-link gears, the arrangement is often roughly determined based solely on the gear arrangement space, ensuring that the multi-link gears can be disposed within the designated space without considering NVH design issues. This often leads to phase superposition of the transmission error excitation of the multi-link gears, which represents the degree of howling generated by the multi-link gears. The phase superposition of the transmission error excitation of the multi-link gears can result in a greater degree of howling, leading to increased noise generated by the multi-link gears and subsequently more severe NVH issues.

In the embodiments of the present disclosure, when arranging the multi-link gears, not only the gear arrangement space is considered, but also the overall transmission error excitation of the multi-link gears, which represents the degree of howling generated by the multi-link gears, is considered. Therefore, selecting the first target arrangement angle with the minimum overall transmission error excitation from a plurality of first candidate arrangement angles can reduce the noise of the multi-link gears. Thus, the embodiments of the present disclosure not only enable the arranged multi-link gears to meet the overall arrangement space and dimensional requirements of the entire box, that is, to achieve lightweight design, but also reduce the noise of the multi-link gears, that is, to ensure the NVH performance of the gears.

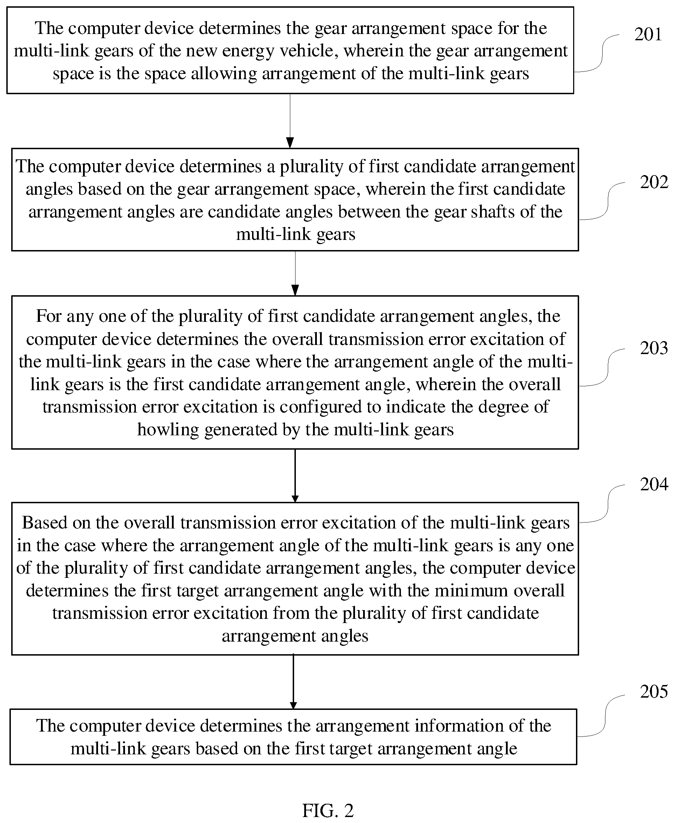

FIG. 2 illustrates a flowchart of a method for arranging the multi-link gears in a new energy vehicle according to some embodiments of the present disclosure. Referring to FIG. 2, the method includes the following processes.

In process 201, the computer device determines the gear arrangement space for the multi-link gears of the new energy vehicle, wherein the gear arrangement space is the space allowing arrangement of the multi-link gears.

The developer sets up the design drawing of the new energy vehicle in advance, which marks the gear arrangement space for the multi-link gears. In this process, the computer device determines the gear arrangement space for the multi-link gears from the design drawing of the new energy vehicle.

The multi-link gears are between the motor and engine of a new energy vehicle or in the form of multi-power coupling. Therefore, the solution according to the embodiments of the present disclosure can be applied to the design of multi-link gears or coaxial gear shaft systems in the multi-power coupling structure of new energy transmissions. The NVH design method for the multi-link gears or coaxial shaft system arrangement according to the embodiments of the present disclosure can be used in the gear shaft design of any transmission or mechanical system with high NVH performance requirements. The specific design form can be optimized in various dimensions based on the actual structural form and analysis results.

In process 202, the computer device determines a plurality of first candidate arrangement angles based on the gear arrangement space, wherein the first candidate arrangement angles are candidate angles between the gear shafts of the multi-link gears.

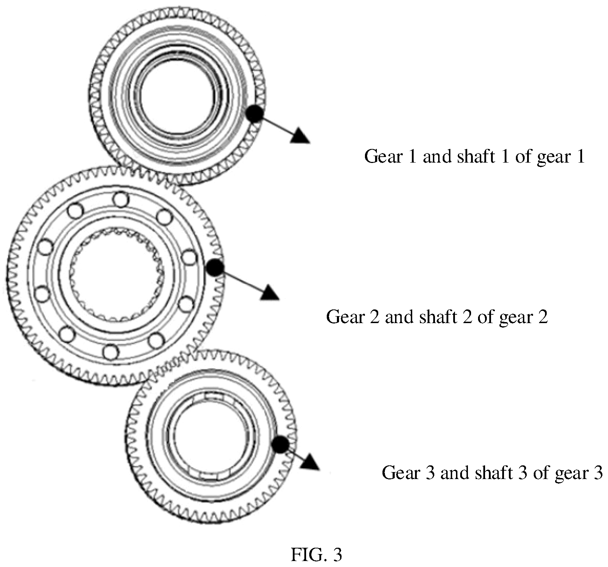

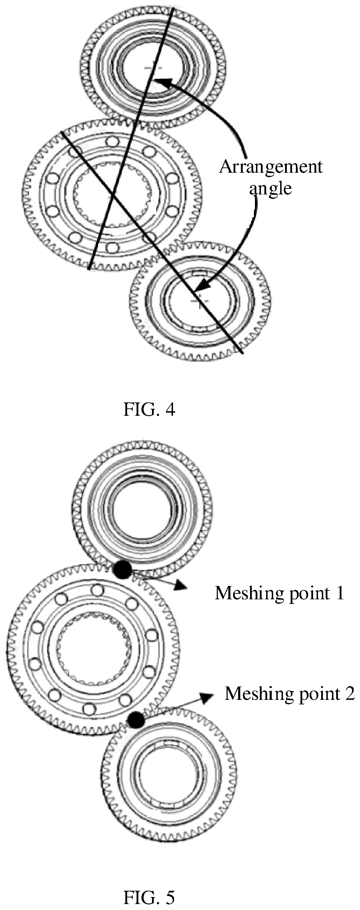

The multi-link gears include a plurality of gears meshed sequentially. For example, referring to FIG. 3, the multi-link gears include gear 1, gear 2, and gear 3 meshed sequentially. In FIG. 3, the gear shaft where gear 1 is disposed, the gear shaft where gear 2 is disposed, and the gear shaft where gear 3 is disposed are marked. The first candidate arrangement angle is the angle between the line formed by the center points of two adjacent gears of the plurality of gears meshed sequentially. For example, referring to FIG. 4, gear 1 meshes with gear 2, gear 2 meshes with gear 3, the center point of gear 1 and the center point of gear 2 form a first boundary line, the center point of gear 2 and the center point of gear 3 form a second boundary line, and the first boundary line and the second boundary line form the first candidate arrangement angle.

In process 203, for any one of the plurality of first candidate arrangement angles, the computer device determines the overall transmission error excitation of the multi-link gears in the case where the arrangement angle of the multi-link gears is the first candidate arrangement angle, wherein the overall transmission error excitation is configured to indicate the degree of howling generated by the multi-link gears.

The overall transmission error excitation is positively correlated with the degree of howling produced by the multi-link gears. That is, the greater the overall transmission error excitation, the louder the howling produced by the multi-link gears, and the louder the noise generated by the multi-link gears. Conversely, the smaller the overall transmission error excitation, the less howling produced by the multi-link gears, and the less noise generated by the multi-link gears.

In one possible implementation, this process may be achieved through the following steps (1) and (2).
(1) The computer device determines, in the case where the arrangement angle of the multi-link gears is the first candidate arrangement angle, the phase of the transmission error excitation at a plurality of meshing points of the multi-link gears. Different meshing points correspond to different phases of transmission error excitation, and the transmission error excitation at the meshing points is configured to indicate the degree of howling generated at the meshing points.

The phase of the transmission error excitation is configured to indicate the direction of the transmission error excitation. When the phases of the transmission error excitation at a plurality of meshing points are exactly opposite, the transmission error excitations at the meshing points can cancel each other out, thereby reducing the howling generated by the multi-link gears and subsequently lowering the noise level. The meshing point refers to the location where two gears mesh. For example, referring to FIG. 5, FIG. 5 marks the meshing points between gear 1 and gear 2, and the meshing points between gear 2 and gear 3.

In one possible implementation, this process may be achieved through the following steps (1-1) to (1-2).

(1-1) The computer device determines, in the case where the arrangement angle of the multi-link gears is the first candidate arrangement angle, the transmission error of the plurality of meshing points. Different meshing points correspond to different transmission errors, and the transmission error of a meshing point is the deviation between the actual position and the theoretical position of the multi-link gears when the multi-link gears engage at the meshing point.

For any meshing point, the computer device determines the actual position and theoretical position of the meshing point, and calculates the deviation between the actual position and theoretical position to acquire the transmission error of the meshing point. Because there are a plurality of meshing points, the computer device can determine the transmission errors of the plurality of meshing points.

(1-2) For any one of the plurality of meshing points, the computer device performs Fourier decomposition on the transmission error of the meshing point to acquire the phase of the transmission error excitation at the meshing point.

The phase of the transmission error excitation at the meshing point is either the phase of the fundamental frequency of the transmission error at the meshing point or the phase of the harmonic frequency of the transmission error. Furthermore, by Fourier decomposition of the transmission error at the meshing point, the computer device can also acquire the amplitude of the transmission error excitation at the meshing point, the transmission error excitation at the meshing point, which can be either the amplitude of the fundamental frequency of the transmission error at the meshing point or the amplitude of the plurality of frequency of the transmission error.

(2) The computer device determines the overall transmission error excitation of the multi-link gears based on the phase of the transmission error excitation at the plurality of meshing points.

The computer device superimposes the phases of the transmission error excitation from the plurality of meshing points to acquire the overall transmission error excitation of the multi-link gears. For example, the plurality of meshing points include meshing point 1 and meshing point 2, and the phases of the transmission error excitation at meshing point 1 and meshing point 2 are +30 and -30 respectively, then the computer device superimposes the phases of the transmission error excitation at the plurality of meshing points, resulting in an overall transmission error excitation of 0 for the multi-link gears. In this case, the transmission error excitations at the plurality of meshing points cancel each other out, thereby reducing the overall transmission error excitation of the multi-link gears.

In one possible implementation, the computer device can further determine the overall transmission error excitation of the multi-link gears by combining the amplitude of the transmission error excitation. Correspondingly, in this process, the computer device determines the overall transmission error excitation of the multi-link gears based on the phases and amplitudes of the transmission error excitations at the plurality of meshing points.

The process for the computer device to determine the overall transmission error excitation of the multi-link gears based on the phases and amplitudes of the transmission error excitations at the plurality of meshing points can be as follows. The computer device superimposes the phases and amplitudes of the transmission error excitations at the plurality of meshing points to acquire the overall transmission error excitation of the multi-link gears. For example, in the case where the plurality of meshing points include meshing point 1 and meshing point 2, and the phases of the transmission error excitation at meshing point 1 and meshing point 2 are +30 and -30 respectively, and the amplitudes of the transmission error excitation at meshing point 1 and meshing point 2 are both 10, then the transmission error excitation at the plurality of meshing points is exactly fully transmitted, thereby reducing the overall transmission error excitation of the multi-link gears.

In process 204, based on the overall transmission error excitation of the multi-link gears in the case where the arrangement angle of the multi-link gears is any one of the plurality of first candidate arrangement angles, the computer device determines the first target arrangement angle with the minimum overall transmission error excitation from the plurality of first candidate arrangement angles.

The overall transmission error excitation is configured to indicate the degree of howling generated by multi-link gears. Therefore, the computer device selecting the first target arrangement angle with the minimum overall transmission error excitation from the plurality of first candidate arrangement angles can reduce the noise of multi-link gears.

In one possible implementation, in the case where the overall transmission error excitation includes both phase and amplitude, the computer device determines the first target arrangement angle with the minimum phase from the plurality of first candidate arrangement angles based on the phase of the overall transmission error excitation of the multi-link gears in the case where the arrangement angle of the multi-link gears is any one of the plurality of first candidate arrangement angles. In the case where there are a plurality of overall transmission error excitations with the same minimum phase, the computer device selects the overall transmission error excitation with the minimum amplitude from these excitations, and determines the first candidate arrangement angle corresponding to the excitation as the first target arrangement angle.

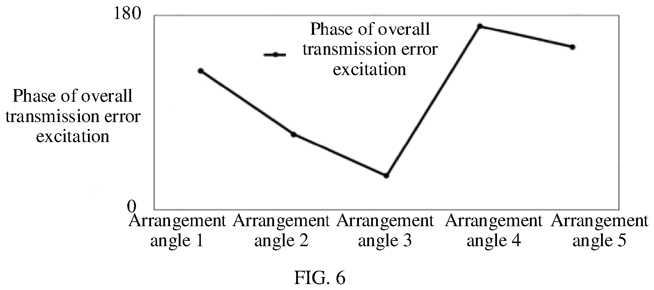

For example, referring to FIG. 6, the plurality of first candidate arrangement angles are angle 1, angle 2, angle 3, angle 4, and angle 5. The phases of the overall transmission error excitation corresponding to angle 1, angle 2, angle 3, angle 4, and angle 5 are marked in FIG. 6. As illustrated in FIG. 6, the phase of the overall transmission error excitation corresponding to angle 3 is the smallest. Therefore, the first target arrangement angle is determined to be angle 3.

In the embodiments of the present disclosure, because the dimension of gear arrangement space is considered when determining the plurality of first candidate arrangement angles, the embodiments of the present disclosure can determine the arrangement of multi-link gears by combining dimensions such as overall box size and lightweight.

In process 205, the computer device determines the arrangement information of the multi-link gears based on the first target arrangement angle.

The arrangement information of the multi-link gears is configured to indicate the arrangement angles between the gear shafts of the multi-link gears. In the where that the computer device determines the arrangement information of the multi-link gears, the computer device arranges the multi-link gears based on the arrangement information. For example, the computer device determines the arrangement angles between the gear shafts of the multi-link gears as the first target arrangement angles.

In the embodiments of the present disclosure, when arranging the multi-link gears, not only is the gear arrangement space considered, but also the overall transmission error excitation of the multi-link gears, which represents the degree of howling generated by the multi-link gears, is considered. Therefore, selecting the first target arrangement angle with the minimum overall transmission error excitation from the plurality of first candidate arrangement angles can reduce the noise of the multi-link gears. Consequently, the embodiments of the present disclosure not only enable the arranged multi-link gears to meet the overall arrangement space and dimensional requirements of the entire box, that is, to achieve lightweight design, but also reduce the noise of the multi-link gears, that is, to ensure the NVH performance of the gears.

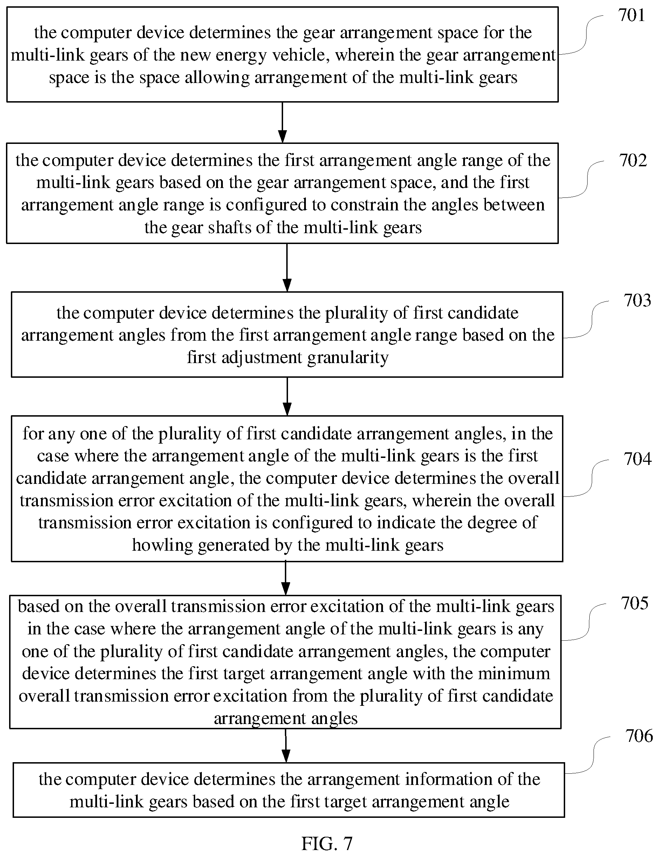

FIG. 7 illustrates a flowchart of a method for arranging the multi-link gears in a new energy vehicle according to some embodiments of the present disclosure. Referring to FIG. 7, the method includes the following processes.

In process 701, the computer device determines the gear arrangement space for the multi-link gears of the new energy vehicle, wherein the gear arrangement space is the space allowing arrangement of the multi-link gears.

In some embodiments, this process is the same as process 201, which is not repeated herein.

In process 702, the computer device determines the first arrangement angle range of the multi-link gears based on the gear arrangement space, and the first arrangement angle range is configured to constrain the angles between the gear shafts of the multi-link gears.

In the embodiments of the present disclosure, the computer device utilizes CAE research and analysis methods. Initially, feasible candidate arrangement angles are selected, and the inter-axis angles are treated as design variables for angle optimization according to a certain shaft rotation method. Based on the gear arrangement space, a slightly larger angle interval can be adopted for the first round of optimization to conduct a rough search. According to the comparison results, the optimal arrangement angle range is preliminarily determined, followed by the second round of optimization to further narrow the angle range and complete precise optimization. Correspondingly, this process can be implemented by the following steps (1) to (4).
(1) The computer device determines a plurality of second candidate arrangement angles from the gear arrangement space based on the second adjustment granularity.

This design method first considers the available space for shafting arrangement within the entire box boundary, and adopts the form of fixing one shaft and rotating the other shafts, or rotating one shaft and fixing the other shafts, according to the feasible spatial range. The shafting rotates in a clockwise or counterclockwise direction, with each shaft in a different relative position, causing the angle between the shafts to change, and the gear meshing position follows the change. Finally, the gear meshing condition is adjusted by adjusting the angle between the shafts.

In one possible implementation, the plurality of second candidate arrangement angles are determined by fixing one shaft and rotating the other shafts. Correspondingly, in this process, the computer device determines the shaft where the multi-link gears is disposed, acquires a plurality of gear shafts, and determines the second gear shaft from the plurality of gear shafts; and the computer device fixes the first gear shaft, and based on the second adjustment granularity, controls other gear shafts of the plurality of gear shafts in the gear arrangement space to rotate to acquire the plurality of second candidate arrangement angles. During selection of the other gear shafts of the plurality of gear shafts in the gear arrangement space, the gear shaft may be rotated clockwise or counterclockwise.

Due to the presence of the plurality of gear shafts, the computer device can fix one gear shaft at a time and determine plurality of second candidate arrangement angles by rotating the other shafts. For example, there are three gear shafts, i.e., a gear shaft 1, a gear shaft 2, and a gear shaft 3. The computer device fixes the gear shaft 1 and rotates the gear shafts 2 and 3 to acquire the plurality of second candidate arrangement angles 1. Then, the computer device fixes the gear shaft 2 and rotates the gear shafts 1 and 3 to acquire the plurality of second candidate arrangement angles 2. Then, the computer device fixes the gear shaft 3 and rotates the gear shafts 1 and 2 to acquire the plurality of second candidate arrangement angles 3. The plurality of second candidate arrangement angles 1, the plurality of second candidate arrangement angles 2, and the plurality of second candidate arrangement angles 3 are the final determined plurality of second candidate arrangement angles.

In another possible implementation, the plurality of second candidate arrangement angles are determined by rotating one of the shafts when fixing the other shafts. Correspondingly, in this process, the computer device determines the shafts where the multi-link gears are disposed, acquires a plurality of gear shafts, and determines the second gear shaft from the plurality of gear shafts, the second gear shaft; and the computer device fixes other gear shafts of the plurality of gear shafts, and based on the second adjustment granularity, causes the second gear shaft within the gear arrangement space to rotate to acquire the plurality of second candidate arrangement angles. During rotation of the second gear shaft within the gear arrangement space, the second gear shaft may be rotated clockwise or counterclockwise.

(2) For any one of the plurality of second candidate arrangement angles, in the case where the computer device determines the arrangement angle of the multi-link gears to be the second candidate arrangement angle, the computer device determines the overall transmission error excitation of the multi-link gears.

The process of overall transmission error excitation of the multi-link gears in the case where the computer device determines the arrangement angle of the multi-link gears as the second candidate arrangement angle is similar to the process of overall transmission error excitation of the multi-link gears in the case where the computer device determines the arrangement angle of the multi-link gears as the first candidate arrangement angle, which is not be repeated herein.

(3) Based on the overall transmission error excitation of the multi-link gears in the case where the arrangement angle of the multi-link gears is any one of the plurality of second candidate arrangement angles, the computer device determines a plurality of second target arrangement angles from the plurality of second candidate arrangement angles where the overall transmission error excitation is less than a predetermined error excitation.

(4) The computer device forms the first arrangement angle range of the multi-link gears from the plurality of second target arrangement angles.

In one possible implementation, in the case where the plurality of second target arrangement angles are consecutive angles, the computer device directly combines the plurality of second target arrangement angles to form the first arrangement angle range of the multi-link gears. In the case where the plurality of second target arrangement angles are not consecutive angles, the computer device determines a continuous plurality of angles from the plurality of second target arrangement angles and combines the continuous plurality of angles to form the first arrangement angle range. Alternatively, in the case where the plurality of second target arrangement angles are not consecutive angles, the computer device determines the maximum arrangement angle range formed by the plurality of second target arrangement angles as the first arrangement angle range. Or, in the case where the plurality of second target arrangement angles are not consecutive angles, the computer device determines the minimum arrangement angle range formed by the plurality of second target arrangement angles as the first arrangement angle range.

In process 703, the computer device determines the plurality of first candidate arrangement angles from the first arrangement angle range based on the first adjustment granularity.

The second adjustment granularity is greater than the first adjustment granularity. In one possible implementation, the computer device determines the plurality of first candidate arrangement angles by fixing one shaft and rotating the other shafts. Correspondingly, in the process, the computer device determines the shafts where the multi-link gears are disposed, acquires a plurality of gear shafts, and determines the first gear shaft from the plurality of gear shafts; and the computer device fixes the first gear shaft, and based on the first adjustment granularity, controls the other gear shafts among the plurality of gear shafts within the first arrangement angle range to rotate to acquire the plurality of first candidate arrangement angles.

In another possible implementation, the computer device determines the plurality of second candidate arrangement angles by rotating one of the shafts and fixing the other shafts. Correspondingly, in the process, the computer device determines the shafts where the multi-link gears are disposed, acquires the plurality of gear shafts, and determines the first gear shaft from the plurality of gear shafts; and the computer device fixes the other gear shafts of the plurality of gear shafts, and based on the first adjustment granularity, controls the first gear shaft within the first arrangement angle range to rotate to acquire the plurality of first candidate arrangement angles.

In process 704, for any one of the plurality of first candidate arrangement angles, in the case where the arrangement angle of the multi-link gears is the first candidate arrangement angle, the computer device determines the overall transmission error excitation of the multi-link gears, wherein the overall transmission error excitation is configured to indicate the degree of howling generated by the multi-link gears.

In some embodiments, this process is the same as process 203, which is not repeated herein.

In process 705, based on the overall transmission error excitation of the multi-link gears in the case where the arrangement angle of the multi-link gears is any one of the plurality of first candidate arrangement angles, the computer device determines the first target arrangement angle with the minimum overall transmission error excitation from the plurality of first candidate arrangement angles.

In some embodiments, this process is the same as process 204, which is not repeated herein.

In process 706, the computer device determines the arrangement information of the multi-link gears based on the first target arrangement angle.

In some embodiments, this process is the same as process 205, which is not repeated herein.

In the embodiments of the present disclosure, when determining the plurality of first candidate arrangement angles, a two-round optimization approach is adopted. In the first round, a slightly larger angle interval can be used for rough optimization, and based on the comparison results, a preliminary range of optimal arrangement angles is determined. Then, in the second round, the angle range is further narrowed down to complete precise optimization, thereby improving the efficiency of determining the plurality of first candidate arrangement angles.

In the embodiments of the present disclosure, when arranging multi-link gears, not only is the gear arrangement space considered, but also the overall transmission error excitation of the multi-link gears, which represents the degree of howling generated by the multi-link gears, is considered. Therefore, selecting the first target arrangement angle with the minimum overall transmission error excitation from the plurality of first candidate arrangement angles can reduce the noise of the multi-link gears. Consequently, the embodiments of the present disclosure not only enable the arranged multi-link gears to meet the overall arrangement space and dimensional requirements of the entire box, that is, to achieve lightweight design, but also reduce the noise of the multi-link gears, that is, to ensure the NVH performance of the gears.

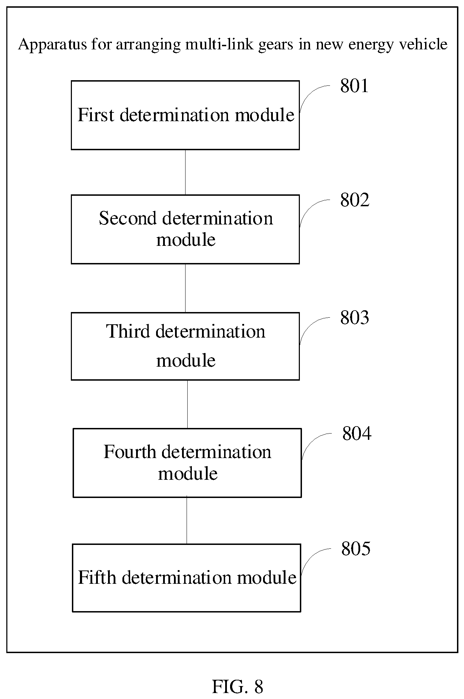

FIG. 8 illustrates a block diagram of an apparatus for arranging multi-link gears in a new energy vehicle according to some embodiments of the present disclosure. The apparatus includes:
a first determination module 801, configured to determine a gear arrangement space for the multi-link gears in the new energy vehicle, wherein the gear arrangement space is a space allowing arrangement of the multi-link gears;
a second determination module 802, configured to determine a plurality of first candidate arrangement angles based on the gear arrangement space, wherein the first candidate arrangement angles are candidate angles between the gear shafts of the multi-link gears;
a third determination module 803, configured to determine, for any of the plurality of first candidate arrangement angles, an overall transmission error excitation of the multi-link gears in the case where the arrangement angle of the multi-link gears is the first candidate arrangement angle, wherein the overall transmission error excitation is configured to indicate the degree of howling generated by the multi-link gears;
a fourth determination module 804, configured to determine the first target arrangement angle with the minimum overall transmission error excitation from the plurality of first candidate arrangement angles, based on the overall transmission error excitation of the multi-link gears in the case where the arrangement angle is any one of the plurality of first candidate arrangement angles; and
a fifth determination module 805, configured to determine the arrangement information of the multi-link gears based on the first target arrangement angle.

In one possible implementation, the third determination module 803 is configured to: determine the phases of the transmission error excitations at a plurality of meshing points of the multi-link gears in the case where the arrangement angle of the multi-link gears is the first candidate arrangement angle, wherein different meshing points correspond to different phases of the transmission error excitations, and the transmission error excitation at the meshing point is configured to indicate the degree of howling generated at the meshing points; and determine, based on the phases of the transmission error excitations at the plurality of meshing points, the overall transmission error excitation of the multi-link gears.

In another possible implementation, the third determination module 803 is configured to: determine the transmission errors of the plurality of meshing points in the case where the arrangement angle of the multi-link gears is the first candidate arrangement angle, wherein different meshing points correspond to different transmission errors, and the transmission error of the meshing point is the deviation between the actual position and the theoretical position of the multi-link gears in the case where the multi-link gears are engaged at the meshing point; and for any of the plurality of meshing points, acquire the phase of the transmission error excitation at the meshing point by performing Fourier decomposition on the transmission error of the meshing point.

In another possible implementation, the second determination module 802 is configured to: determine the first arrangement angle range of the multi-link gears based on the gear arrangement space, wherein the first arrangement angle range is configured to constrain the angles between the gear shafts of the multi-link gears; and determine the plurality of first candidate arrangement angles are determined from the first arrangement angle range based on the first adjustment granularity.

In another possible implementation, the second determination module 802 is configured to: determine the shaft where the multi-link gears are disposed, acquire a plurality of gear shafts, and determine the first gear shaft from the plurality of gear shafts; and acquire the plurality of first candidate arrangement angles by fixing the first gear shaft and rotating the other gear shafts of the plurality of gear shafts within the first arrangement angle range based on the first adjustment granularity; or acquire the plurality of first candidate arrangement angles by fixing the other gear shafts of the plurality of gear shafts and rotating the first gear shaft within the first arrangement angle range based on the first adjustment granularity.

In another possible implementation, the second determination module 802 is configured to: determine a plurality of second candidate arrangement angles from the gear arrangement space based on the second adjustment granularity, wherein the second adjustment granularity is larger than the first adjustment granularity; for any of the plurality of second candidate arrangement angles, determine the overall transmission error excitation of the multi-link gears in the case where the arrangement angle of the multi-link gears is the second candidate arrangement angle; and based on the overall transmission error excitation of the multi-link gears in the case where the arrangement angle is any one of the plurality of second candidate arrangement angles, determine a plurality of second target arrangement angles from the plurality of second candidate arrangement angles where the overall transmission error excitation is less than a predetermined error excitation; and form the first arrangement angle range of the multi-link gears from the plurality of second target arrangement angles.

In the embodiments of the present disclosure, during arrangement of the multi-link gears, not only is the gear arrangement space considered, but also the overall transmission error excitation of the multi-link gears, which represents the degree of howling generated by the multi-link gears, is considered. Therefore, selecting the first target arrangement angle with the minimum overall transmission error excitation from the plurality of first candidate arrangement angles can reduce the noise of the multi-link gears. Thus, the embodiments of the present disclosure not only enable the arranged multi-link gears to meet the overall arrangement space and dimensional requirements of the entire box, that is, to achieve lightweight design, but also reduce the noise of the multi-link gears, that is, to ensure the NVH performance of the gears.

It should be noted that the apparatus for arranging the multi-link gears in the new energy vehicle according to the above embodiments is exemplified by the division of the above functional modules when arranging the multi-link gears in the new energy vehicle. In practical applications, the above functions can be allocated to different functional modules as needed, that is, the internal structure of the computer device may be divided into different functional modules to complete all or part of the functions described above. In addition, the apparatus for arranging the multi-link gears in the new energy vehicle provided in the above embodiments and the embodiments of the method for arranging the multi-link gears in the new energy vehicle belong to the same concept. The specific implementation process is detailed in the method embodiments, which is not repeated herein.

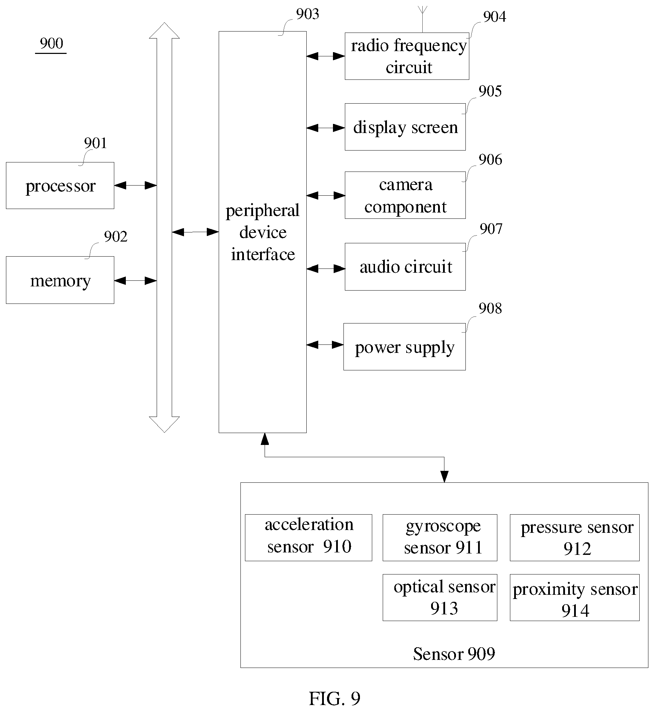

FIG. 9 is a structural block diagram of a computer device 900 according to some embodiments of the present disclosure. The computer device 900 can be a portable mobile terminal, such as a smartphone, tablet computer, moving picture experts group audio layer III (MP3 player), moving picture experts group audio layer IV (MP4) player, laptop, or desktop computer. The computer device 900 may also be referred to as a user device, portable terminal, laptop terminal, desktop terminal, or other names.

Generally, the computer device 900 includes a processor 901 and a memory 902.

The processor 901 includes one or more processing cores, such as a 4-core processor, an 8-core processor, or the like. The processor 901 is implemented by using at least one hardware form of a digital signal processor (DSP), a field-programmable gate array (FPGA), or a programmable logic array (PLA). The processor 901 also includes a main processor and a co-processor. The main processor is a processor configured to process data in the awake state, also known as a central processing unit (CPU). The co-processor is a low-power processor used for processing data in the standby state. In some embodiments, the processor 901 can be integrated with a graphics processing unit (GPU), which is responsible for rendering and drawing the content required to be displayed on the display screen. In some embodiments, the processor 901 can also include an artificial intelligence (AI) processor, which is configured to process computational operations related to machine learning.

The memory 902 includes one or more non-transitory computer-readable storage media. The memory 902 also includes high-speed random-access memory, as well as non-volatile memory, such as one or more disk storage devices, or one or more flash memory storage devices. In some embodiments, the non-transitory computer-readable storage media in the memory 902 are configured to store one or more program codes, wherein the one or more program codes, when loaded and executed by the processor 901, cause the processor 901 to perform the method according to the method embodiments in the present disclosure.

In some embodiments, the computer device 900 includes a peripheral device interface 903 and at least one peripheral device. The processor 901, the memory 902, and the peripheral device interface 903 are connected via a bus or signal line. Each peripheral device can be connected to the peripheral device interface 903 via a bus, a signal line, or a circuit board. Specifically, the peripheral devices include at least one of a radio frequency circuit 904, a display screen 905, a camera component 906, an audio circuit 907, and a power supply 908.

The peripheral device interface 903 can be utilized to connect at least one input/output (I/O) related peripheral device to the processor 901 and the memory 902. In some embodiments, the processor 901, the memory 902, and the peripheral device interface 903 are integrated onto the same chip or circuit board. In other embodiments, any one or two of the processor 901, the memory 902, and the peripheral device interface 903 may be implemented on separate chips or circuit boards, which is not limited in the embodiments.

The radio frequency (RF) circuit 904 is configured to receive and transmit RF signals, also known as electromagnetic signals. The RF circuit 904 communicates with communication networks and other communication devices through electromagnetic signals. The RF circuit 904 converts electrical signals into electromagnetic signals for transmission, or converts received electromagnetic signals into electrical signals. Optionally, the RF circuit 904 includes an antenna system, an RF transceiver, one or more amplifiers, a tuner, an oscillator, a digital signal processor, a codec chipset, a user identity module card, and so on. The RF circuit 904 can communicate with other terminals through at least one wireless communication protocol. The wireless communication protocol includes but is not limited to: the World Wide Web, metropolitan area networks, intranets, various generations of mobile communication networks (2G, 3G, 4G, and 5G), wireless local area networks, and/or wireless fidelity (Wi-Fi) networks. In some embodiments, the RF circuit 904 also includes circuits related to near-field communication (NFC), which is not limited in the present disclosure.

The display screen 905 is configured to display a user interface (UI). The UI includes graphics, text, icons, videos, and any combination thereof. When the display screen 905 is a touch display screen, the display screen 905 also has the ability to capture touch signals on or above its surface. These touch signals can be input as control signals to the processor 901 for processing. At this time, the display screen 905 can also be configured to provide virtual buttons and/or virtual keyboards, also known as soft buttons and/or soft keyboards. In some embodiments, there can be one display screen 905, which is arranged on the front panel of the computer device 900. In another embodiment, there can be at least two display screens 905, which are arranged on different surfaces of the computer device 900 or in a folding design. In still another embodiment, the display screen 905 can be a flexible display screen, arranged on the curved surface or folding surface of the computer device 900. Furthermore, the display screen 905 can also be arranged in a non-rectangular irregular shape, also known as a shaped screen. The display screen 905 may be fabricated using materials such as a liquid crystal display (LCD) or an organic light-emitting diode (OLED).

The camera component 906 is configured to capture images or videos. Optionally, the camera component 906 includes a front camera and a rear camera. Typically, the front camera is arranged on the front panel of the terminal, and the rear camera is arranged on the back of the terminal. In some embodiments, there are at least two rear cameras, which can be any of a main camera, a depth-of-field camera, a wide-angle camera, and a telephoto camera, respectively, to achieve a background blurring function by integrating the main camera and the depth-of-field camera, a panoramic shooting function by integrating the main camera and the wide-angle camera, a virtual reality (VR) shooting function, or other integrated shooting functions. In some embodiments, the camera component 906 can also include a flashlight. The flashlight can be a single-color temperature flashlight or a dual color temperature flashlight. A dual color temperature flashlight refers to a combination of a warm light flashlight and a cool light flashlight, which can be used for light compensation under different color temperatures.

The audio circuit 907 can include a microphone and a speaker. The microphone is used to capture sound waves from the user and the environment, and convert the sound waves into electrical signals that are input to the processor 901 for processing, or input to the radio frequency circuit 904 to enable voice communication. For the purpose of stereo capture or noise reduction, there can be a plurality of microphones, each disposed at different parts of the computer device 900. The microphones can also be array microphones or omnidirectional capture microphones. The speaker is used to convert electrical signals from the processor 901 or the radio frequency circuit 904 into sound waves. The speaker may be a traditional thin-film speaker or a piezoelectric ceramic speaker. When the speaker is a piezoelectric ceramic speaker, it can not only convert electrical signals into sound waves that are audible to humans, but also convert electrical signals into sound waves that are inaudible to humans for purposes such as ranging. In some embodiments, the audio circuit 907 can also include an earphone jack.

The power supply 908 is configured to supply power to various components in the computer device 900. The power supply 908 can be an alternating-current (AC) power supply, a direct-current (DC) power supply, a disposable battery, or a rechargeable battery. When the power supply 908 includes a rechargeable battery, the rechargeable battery can be a wired charging battery or a wireless charging battery. A wired charging battery is a battery that is charged through wired lines, and a wireless charging battery is a battery that is charged through wireless coils. The rechargeable battery can also be used to support fast charging technology.

In some embodiments, the computer device 900 further includes one or more sensors 909. The one or more sensors 909 include, but are not limited to, an acceleration sensor 910, a gyroscope sensor 911, a pressure sensor 912, an optical sensor 913, and a proximity sensor 914.

The acceleration sensor 910 can detect the magnitude of acceleration on the three coordinate axes of the coordinate system established by the computer device 900. For example, the acceleration sensor 910 can be used to detect the components of gravitational acceleration on the three coordinate axes. The processor 901 can control the display screen 905 to display the user interface in landscape or portrait view based on the gravitational acceleration signal captured by the acceleration sensor 910. The acceleration sensor 910 may also be used for game play or the capture of user's motion data.

The gyroscope sensor 911 can detect the body orientation and rotation angle of the computer device 900. The gyroscope sensor 911 can collaborate with the acceleration sensor 910 to capture the user's 3D motions on the computer device 900. Based on the data captured by the gyroscope sensor 911, the processor 901 can implement the following functions: motion sensing (such as changing the UI based on the user's tilt operation), image stabilization during shooting, game control, and inertial navigation.

The pressure sensor 912 can be arranged on the side frame of the computer device 900 and/or on the lower layer of the display screen 905. When the pressure sensor 912 is arranged on the side frame of the computer device 900, the pressure sensor 912 can detect the user's grip signal on the computer device 900, and the processor 901 can recognize the left and right hands or perform shortcut operations based on the grip signal captured by the pressure sensor 912. When the pressure sensor 912 is arranged on the lower layer of the display screen 905, the processor 901 can control the operable controls on the UI interface based on the user's pressure operation on the display screen 905. The operable controls include at least one of button controls, scroll bar controls, icon controls, and menu controls.

The optical sensor 913 is configured to capture the ambient light intensity. In some embodiments, the processor 901 can control the display brightness of the display screen 905 based on the ambient light intensity captured by the optical sensor 913. Specifically, when the ambient light intensity is high, the display brightness of the display screen 905 is increased. When the ambient light intensity is low, the display brightness of the display screen 905 is decreased. In another embodiment, the processor 901 may also dynamically adjust the shooting parameters of the camera component 906 based on the ambient light intensity captured by the optical sensor 913.

The proximity sensor 914, also known as a distance sensor, is typically disposed on the front panel of the computer device 900. The proximity sensor 914 is configured to capture the distance between the user and the front of the computer device 900. In some embodiments, when the proximity sensor 914 detects that the distance between the user and the front of the computer device 900 is gradually decreasing, the processor 901 controls the display screen 905 to switch from a lit state to a screen-off state. When the proximity sensor 914 detects that the distance between the user and the front of the computer device 900 is gradually increasing, the processor 901 controls the display screen 905 to switch from a screen-off state to a lit state.

Those skilled in the art can understand that the structure shown in FIG. 9 does not constitute a limitation on the computer device 900, and the computer device 900 includes more or fewer components than depicted, or combine certain components, or adopt different component arrangements.

The embodiments of the present disclosure further provide a computer-readable storage medium, in which at least one program code is stored. The at least one program code is loaded and executed by a processor to implement the method for arranging multi-link gears in a new energy vehicle as described in any of the above embodiments. Optionally, the storage medium may be a non-transitory computer-readable storage medium, such as a read-only memory (ROM), a random-access memory (RAM), a compact disc read-only memory (CD-ROM), a magnetic tape, a floppy disk, and an optical data storage device.

The embodiments of the present disclosure also provide a computer program product that stores at least one program code. The at least one program code is loaded and executed by a processor to implement the method for arranging multi-link gears in a new energy vehicle as shown in the various embodiments above.

In some embodiments, the computer program product involved in embodiments of the present disclosure can be deployed to execute on a single computer device, or on a plurality of computer devices disposed at a single site, or on a plurality of computer devices distributed across the plurality of sites and interconnected via a communication network. The plurality of computer devices distributed across the plurality of sites and interconnected via a communication network can constitute a blockchain system.

Those skilled in the art can understand that all or part of the processes for implementing the above embodiments may be implemented through hardware, or by instructing relevant hardware through a program. The program can be stored in a computer-readable storage medium, and the aforementioned storage medium can be a read-only memory, a magnetic disk, an optical disk, or the like.

The above description is intended to facilitate the understanding of the technical solution of the present disclosure by those skilled in the art, and is not intended to limit the present disclosure. Any modifications, equivalent substitutions, improvements, or the like made within the spirit and principles of the present disclosure shall be included within the scope of protection of the present disclosure.

## Claims

1. A method for arranging multi-link gears in a new energy vehicle, comprising:
determining a gear arrangement space for the multi-link gears of the new energy vehicle, wherein the gear arrangement space is a space allowing arrangement of the multi-link gears;
determining a plurality of first candidate arrangement angles based on the gear arrangement space, wherein the plurality of first candidate arrangement angles are candidate angles between gear shafts of the multi-link gears;
determining, for any one of the plurality of first candidate arrangement angles, an overall transmission error excitation of the multi-link gears in a case where an arrangement angle of the multi-link gears is the first candidate arrangement angle, wherein the overall transmission error excitation is configured to indicate a degree of howling generated by the multi-link gears;
determining, based on the overall transmission error excitation of the multi-link gears in the case where the arrangement angle of the multi-link gears is any one of the plurality of first candidate arrangement angles, a first target arrangement angle with a minimum overall transmission error excitation from the plurality of first candidate arrangement angles; and
determining arrangement information of the multi-link gears based on the first target arrangement angle.

2. The method according to claim 1, wherein determining the overall transmission error excitation of the multi-link gears in the case where the arrangement angle of the multi-link gears is the first candidate arrangement angle comprises:
determining phases of transmission error excitations at a plurality of meshing points of the multi-link gears in the case where the arrangement angle of the multi-link gears is the first candidate arrangement angle, wherein the meshing points are in one-to-one correspondence with different phases of the transmission error excitations, and the transmission error excitation at each of the meshing points is configured to indicate the degree of howling generated at the meshing point; and
determining the overall transmission error excitation of the multi-link gears based on the phases of the transmission error excitations at the plurality of meshing points.

3. The method according to claim 2, wherein determining the phases of the transmission error excitations of the plurality of meshing points of the multi-link gears in the case where the arrangement angle of the multi-link gears is the first candidate arrangement angle comprises:
determining transmission errors of the plurality of meshing points in the case where the arrangement angle of the multi-link gears is the first candidate arrangement angle, wherein different meshing points correspond to different transmission errors, and the transmission error of the meshing point is a deviation between an actual position and a theoretical position of the multi-link gears in a case where the multi-link gears are engaged at the meshing point; and
for any one of the plurality of meshing points, acquiring the phase of the transmission error excitation at the meshing point by performing Fourier decomposition on the transmission error of the meshing point.

4. The method according to any one of claims 1 to 3, wherein determining the plurality of first candidate arrangement angles based on the gear arrangement space comprises:
determining a first arrangement angle range of the multi-link gears based on the gear arrangement space, wherein the first arrangement angle range is configured to constrain angles between the gear shafts of the multi-link gears; and
determining the plurality of first candidate arrangement angles from the first arrangement angle range based on a first adjustment granularity.

5. The method according to claim 4, wherein determining the plurality of first candidate arrangement angles from the first arrangement angle range based on the first adjustment granularity comprises:
determining shafts on which the multi-link gears are disposed, acquiring a plurality of gear shafts, and determining a first gear shaft from the plurality of gear shafts; and
acquiring the plurality of first candidate arrangement angles by fixing the first gear shaft and rotating other gear shafts of the plurality of gear shafts within the first arrangement angle range based on the first adjustment granularity; or acquiring the plurality of first candidate arrangement angles by fixing other gear shafts of the plurality of gear shafts and rotating the first gear shaft within the first arrangement angle range based on the first adjustment granularity.

6. The method according to claim 4, wherein determining the first arrangement angle range of the multi-link gears based on the gear arrangement space comprises:
determining a plurality of second candidate arrangement angles from the gear arrangement space based on a second adjustment granularity, wherein the second adjustment granularity is larger than the first adjustment granularity;
for any one of the plurality of second candidate arrangement angles, determining the overall transmission error excitation of the multi-link gears in a case where the arrangement angle of the multi-link gears is the second candidate arrangement angle;
determining, based on the overall transmission error excitation of the multi-link gears in a case where the arrangement angle of the multi-link gears is any one of the plurality of second candidate arrangement angles, a plurality of second target arrangement angles from the plurality of second candidate arrangement angles where the overall transmission error excitation is less than a predetermined error excitation; and
forming the first arrangement angle range of the multi-link gears from the plurality of second target arrangement angles.

7. An apparatus for arranging multi-link gears in a new energy vehicle, comprising:
a first determination module, configured to determine a gear arrangement space for the multi-link gears in the new energy vehicle, wherein the gear arrangement space is a space allowing arrangement of the multi-link gears;
a second determination module, configured to determine a plurality of first candidate arrangement angles based on the gear arrangement space, wherein the first candidate arrangement angles are candidate angles between gear shafts of the multi-link gears;
a third determination module, configured to determine, for any one of the plurality of first candidate arrangement angles, an overall transmission error excitation of the multi-link gears in a case where the arrangement angle of the multi-link gears is any one of the plurality of first candidate arrangement angles, wherein the overall transmission error excitation is configured to indicate a degree of howling generated by the multi-link gears;
a fourth determination module, configured to determine a first target arrangement angle with a minimum overall transmission error excitation from the plurality of first candidate arrangement angles based on the overall transmission error excitation of the multi-link gears in a case where the arrangement angle of the multi-link gears is any one of the plurality of first candidate arrangement angles; and
a fifth determination module, configured to determine arrangement information of the multi-link gears based on the first target arrangement angle.

8. The apparatus according to claim 7, wherein the third determination module is configured to: determine phases of transmission error excitations at a plurality of meshing points of the multi-link gears in the case where the arrangement angle of the multi-link gears is the first candidate arrangement angle, wherein different meshing points correspond to different phases of the transmission error excitations, and the transmission error excitation at the meshing point is configured to indicate the degree of howling generated at the meshing point; and determine, based on the phases of the transmission error excitations at the plurality of meshing points, the overall transmission error excitation of the multi-link gears.

9. The apparatus according to claim 8, wherein the third determination module is configured to: determine transmission errors of the plurality of meshing points in the case where the arrangement angle of the multi-link gears is the first candidate arrangement angle, wherein different meshing points correspond to different transmission errors, and the transmission error of the meshing point is a deviation between an actual position and a theoretical position of the multi-link gears in a case where the multi-link gears are engaged at the meshing point; and for any one of the plurality of meshing points, acquire the phase of the transmission error excitation at the meshing point by performing Fourier decomposition on the transmission error of the meshing point.

10. The apparatus according to any one of claims 7 to 9, wherein the second determination module is configured to: determine a first arrangement angle range of the multi-link gears based on the gear arrangement space, wherein the first arrangement angle range is configured to constrain angles between the gear shafts of the multi-link gears; and determine the plurality of first candidate arrangement angles from the first arrangement angle range based on a first adjustment granularity.

11. The apparatus according to claim 10, wherein the second determination module is configured to: determine the shaft on which the multi-link gears are disposed, acquire a plurality of gear shafts, and determine a first gear shaft from the plurality of gear shafts; and acquire the plurality of first candidate arrangement angles by fixing the first gear shaft and rotating other gear shafts of the plurality of gear shafts within the first arrangement angle range based on the first adjustment granularity; or acquire the plurality of first candidate arrangement angles by fixing other gear shafts of the plurality of gear shafts and rotating the first gear shaft within the first arrangement angle range based on the first adjustment granularity.

12. The apparatus according to claim 10, wherein the second determination module is configured to: determine a plurality of second candidate arrangement angles from the gear arrangement space based on a second adjustment granularity, wherein the second adjustment granularity is larger than the first adjustment granularity; for any one of the plurality of second candidate arrangement angles, determine the overall transmission error excitation of the multi-link gears in a case where the arrangement angle of the multi-link gears is the second candidate arrangement angle; and based on the overall transmission error excitation of the multi-link gears in a case where the arrangement angle of the multi-link gears is any one of the plurality of second candidate arrangement angles, determine a plurality of second target arrangement angles from the plurality of second candidate arrangement angles where the overall transmission error excitation is less than a predetermined error excitation; and form the first arrangement angle range of the multi-link gears from the plurality of second target arrangement angles.

13. A computer device, comprising: a processor and a memory, wherein one or more program codes are stored in the memory, the processor, when loading and executing the one or more program codes, is caused to perform the method as defined in any one of claims 1 to 6.

14. A computer-readable storage medium, storing one or more program codes therein, wherein the one or more program codes, when loaded and executed by a processor, cause the processor to perform the method as defined in any one of claims 1 to 6.

15. A computer program product, wherein the product stores one or more program codes, and the one or more program codes, when executed by a processor, cause the processor to perform the method as defined in any one of claims 1 to 6.
